# EUROPEAN PATENT APPLICATION

(11) **EP 0 543 313 A1**
(43) Date of publication of application: **26.05.1993**
(21) Application number: 92119574.9
(22) Date of filing: 16.11.1992
(51) Int. Cl.: H01L 29/784, H01L 29/08, H01L 29/72

(54) **Field effect transistor having back gate held in contact with source electrode without variation in source contact resistance**

(30) Priority: 20.11.1991 JP 304305/91
(71) Applicant: NEC CORPORATION, Tokyo (JP)
(72) Inventor: Sakai, Kazuhiko, c/o NEC Corporation, Tokyo (JP)
(74) Representative: Glawe, Delfs, Moll & Partner

(57) **Abstract**

A field effect transistor has a back gate associated with a channel region between a source region (24a/ 24b) and a drain region, and the source region and an ohmic contact region (25a/ 25b) contiguous to the back gate are coupled with a source electrode, wherein the source contact area and the ohmic contact area are respectively broken down into a plurality of source contact sub-areas (241/ 242) and a plurality of ohmic contact sub-areas (251/ 252) arranged in such a manner that the plurality of source contact sub-areas alternate with the plurality of ohmic contact sub-areas in a direction (F) of long edges of the source electrode so that the amount of the source contact area is constant in spite of misalignment of a photo-mask for a source contact hole in a direction of short edges of the source electrode.

## Description

### FIELD OF THE INVENTION

This invention relates to a field effect transistor and, more particularly, to arrangement between source contact areas and ohmic contact areas of a back gate incorporated in the field effect transistor.

### DESCRIPTION OF THE RELATED ART

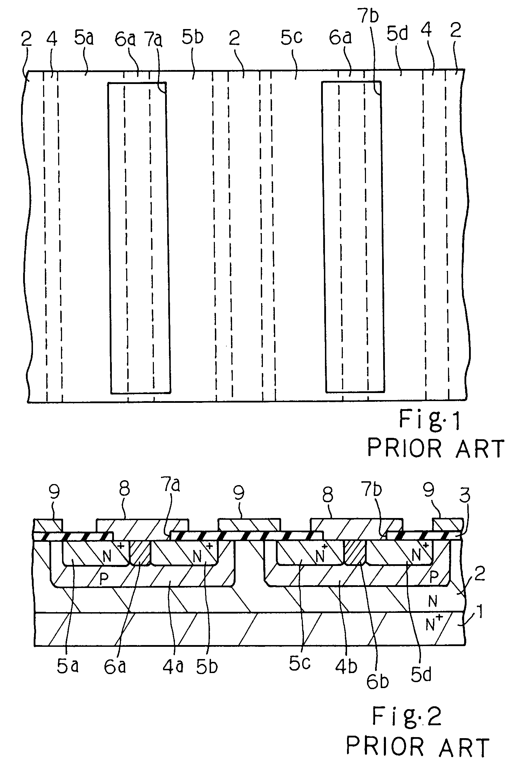

Referring to Figs. 1 and 2, a typical example of a power transistor is implemented by an n-channel vertical MOS field effect transistor, and the n-channel vertical MOS field effect transistor is fabricated on a heavily doped n-type silicon bulk 1 serving as a drain. An n-type epitaxial silicon layer 2 is grown on the heavily doped n-type silicon bulk 1, and a silicon oxide film 3 covers the entire surface of the n-type epitaxial silicon layer 2. In the n-type epitaxial silicon layer 2 are formed p-type impurity regions 4a and 4b spaced from one another which serve as a back gate of the n-channel vertical MOS field effect transistor. A plurality of heavily doped n-type source regions 5a, 5b, 5c and 5d are formed in the p-type back gate regions 4a and 4b, and as a whole constitute a source of the n-channel vertical MOS field effect transistor. The n-type source regions 5a and 5c are spaced apart from the n-type source regions 5b and 5d by heavily doped p-type regions 6a and 6b which are respectively held in contact with the p-type back gate regions 4a and 4b. The heavily doped source regions 5a to 5d and the heavily doped p-type regions 6a and 6b are arranged in strips as will be better seen from Fig. 1. Source contact holes 7a and 7b are formed in the silicon oxide film 3, and each of the source contact boles 7a and 7b exposes not only the associated heavily doped p-type region 6a or 6b but also peripheral areas of the n-type source regions 5a/ 5b or 5c/ 5d on both sides of the associated heavily doped p-type region 6a or 6b. Source electrode 8 are patterned on the silicon oxide film 3, and are held in contact through the source contact holes 7a and 7b with the source regions 5a/ 5b and 5c/ 5d as well as the associated heavily doped p-type regions 6a and 6b. As a result, the source electrodes 8 are connected through the heavily doped p-type regions 6a and 6b with the p-type back gate regions 4a and 4b in ohmic manner. Gate electrodes 9 are further patterned on the silicon oxide film 3, and are located over peripheral areas of the p-type back gate regions 4a and 4b and the n-type epitaxial silicon layer 2 therebetween. The source electrodes 8 and the gate electrodes 9 are deleted from the plan view shown in Fig. 1 for the sake of better understanding of the relation between the stripe shaped heavily doped p-type regions 6a and 6b and the source contact holes 7a and 7b.

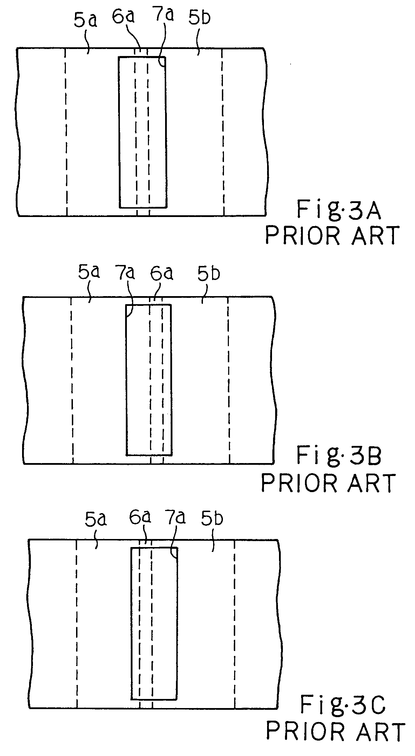

A problem is encountered in the prior art vertical MOS field effect transistor in that the real estate occupied by the transistor is hardly shrinkable in the lateral direction of Fig. 1. In detail, the source contact holes 7a and 7b are patterned through a lithographic process, and a photo-mask tends to be misaligned in the lithographic process. This results in variation in relative relation between the source contact holes 7a and 7b and the associated n-type source regions 5a/ 5b and 5c/ 5d as shown in Figs. 3A to 3C. If each source contact hole 7a or 7b is narrow, the contact hole 7a or 7b is held in contact with either n-type source region 5a/ 5c or 5b/ 5d at a small amount of area, and the source contact resistance is undesirably increased, thereby causing transistor characteristics to fluctuate. For this reason, the source contact holes 7a and 7b need additional width so as to keep the transistors characteristics constant, and the n-type source regions 5a to 5d are, accordingly, elongated in the lateral distance. This results in that the occupation area is hardly shrunk in the lateral direction. In other words, there is a trade-off between the transistor characteristics and the amount of the occupation area.

### SUMMARY OF THE INVENTION

It is therefore an important object of the present invention to provide a field effect transistor which is stable in transistor characteristics without sacrifice of the occupation area.

To accomplish the object, the present invention proposes to alternately repeat a source contact sub-area and an ohmic contact sub-area in a longitudinal direction of a source contact hole.

In accordance with the present invention, there is provided a field effect transistor fabricated on a semiconductor substrate, comprising: a) a source region formed in the semiconductor substrate, and having a source contact area broken down into a plurality of source contact sub-areas; b) a drain region formed in the semiconductor substrate, and spaced apart from the source region by a channel region; c) a back gate formed in the semiconductor substrate, and associated with the channel region; d) an ohmic contact region held in contact with the back gate, and having an ohmic contact area broken down into a plurality of ohmic contact sub-areas, the plurality of source contact sub-areas alternating with the plurality of ohmic contact sub-areas in a first direction; e) a gate electrode provided in association with the channel region for producing a conductive channel; and f) a source electrode having a pair of long edges extending in parallel to the first direction and a pair of short edges extending in perpendicular to the first direction, and held in contact with the source contact area as well as the ohmic contact area.

### BRIEF DESCRIPTION OF THE DRAWINGS

The features and advantages of the field effect transistor according to the present invention will be more clearly understood from the following description taken in conjunction with the accompanying drawings in which:
Fig. 1 is a plan view showing the layout of the prior art field effect transistor;
Fig. 2 is a cross sectional view showing the structure of the prior art field effect transistor;
Figs. 3A to 3C are plan views showing the variation due to the misalignment of the photomask for the source contact holes;
Fig. 4 is a plan view showing the layout of a vertical field effect transistor according to the present invention;
Fig. 5 is a cross sectional view showing the structure of the vertical field effect transistor;
Figs. 6A to 6C are plan views showing variation of relative relation between a source contact hole and a source contact area/ an ohmic contact area;
Fig. 7 is a plan view showing the layout of another field effect transistor according to the present invention; and
Fig. 8 is a plan view showing the structure of the field effect transistors shown in Fig. 7.

### DESCRIPTION OF THE PREFERRED EMBODIMENTS

### First Embodiment

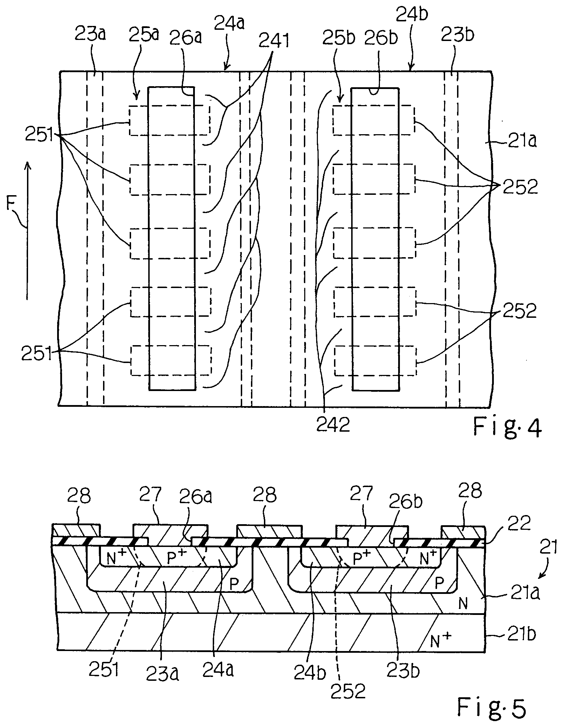

Referring to Figs. 4 and 5 of the drawings, a power transistor is implemented by an n-channel vertical field effect transistor, and the n-channel vertical field effect transistor is of the MOS type. An n-type epitaxial silicon layer 21a is grown on a heavily doped n-type silicon bulk 21b serving as a drain of the n-channel vertical field effect transistor, and the n-type epitaxial silicon layer 21a and the heavily doped silicon bulk 21b form in combination a semiconductor substrate 21. A silicon oxide film 22 is thermally grown on the n-type epitaxial silicon layer 21a, and covers the entire surface thereof.

In the n-type epitaxial silicon layer 21a are formed p-type back gate regions 23a and 23b spaced from one another, and the p-type back gate regions 23a and 23b as a whole constitute a back gate of the n-channel vertical field effect transistor. A plurality of heavily doped n-type source regions 24a and 24b are formed in the p-type back gate regions 23a and 23b, and as a whole constitute a source of the n-channel vertical field effect transistor. In the n-type source regions 24a and 24b are respectively formed heavily doped p-type ohmic contact regions 25a and 25b which are implemented by two columns of ohmic contact sub-regions 251 and 252. The columns of ohmic contact sub-regions 251 and 252 are respectively held in contact with the p-type back gate regions 23a and 23b, and the columns of ohmic contact sub-regions 251 and 252 are arranged to extend in a first direction F. The ohmic contact sub-regions 251 are spaced apart from one another, and the ohmic contact sub-regions 252 are also arranged at spacings. As a result, a plurality of source sub-regions 241 are formed between the ohmic contact sub-regions 251 in such a manner as to alternate with the ohmic contact sub-regions 251, and, similarly, the ohmic contact sub-regions 252 alternate with a plurality of source sub-regions 242.

Source contact holes 26a and 26b are formed in the silicon oxide film 22, and each of the source contact holes 26a and 26b has long edges extending substantially in parallel to the first direction F and short edges extending substantially in perpendicular to the first direction F. Each of the source contact holes 26a and 26b is narrower than the lateral distance of the ohmic contact sub-regions 251 or 252, and is located over the columns of ohmic contact sub-regions 251 or 252. A source electrode 27 is patterned on the silicon oxide film 22, and is held in contact through the source contact holes 26a and 26b with the heavily doped n-type source regions 24a and 24b as well as the associated heavily doped p-type ohmic contact regions 25a and 25b. Since the source electrode 27 is filled in the source contact holes 26a and 26b, the source electrode 27 has long edges extending substantially in parallel to the first direction F and short edges extending substantially in perpendicular to the first direction F. A gate electrode 28 is further patterned on the silicon oxide film 22, and is located over peripheral areas of the p-type back gate regions 23a and 23b and the n-type epitaxial silicon layer 21a therebetween. The source electrode 27 and the gate electrode 28 are deleted from the plan view shown in Fig. 4 as similar to the plan view of the prior art field effect transistor.

Description is made on a process sequence for fabricating the vertical field effect transistor according to the present invention. The process sequence starts with preparation of the heavily doped n-type silicon bulk 21b, and the n-type epitaxial silicon layer 21a is grown on the heavily doped silicon bulk 21b. The n-type epitaxial silicon layer 21a is thermally oxidized, and the silicon oxide film 22 is grown on the entire surface of the n-type epitaxial silicon layer 21a.

A conductive substance is deposited over the entire surface of the silicon oxide film 22, and the silicon oxide film 22 is patterned through a lithographic process so that the gate electrode 28. Using the gate electrode 28 as a mask, p-type dopant is ion-implanted into the n-type epitaxial silicon layer 21a at relatively small dose under relatively large acceleration energy, and the p-type dopant forms the p-type back gate regions 23a and 23b through a heat treatment. Subsequently, n-type dopant is ion-implanted into the p-type back gate regions 23a and 23b at relatively large dose under relatively small acceleration energy. While a heat treatment, the n-type dopant is activated so that the heavily doped n-type source regions 24a and 24b are formed in the p-type back gate regions 23a and 23b.

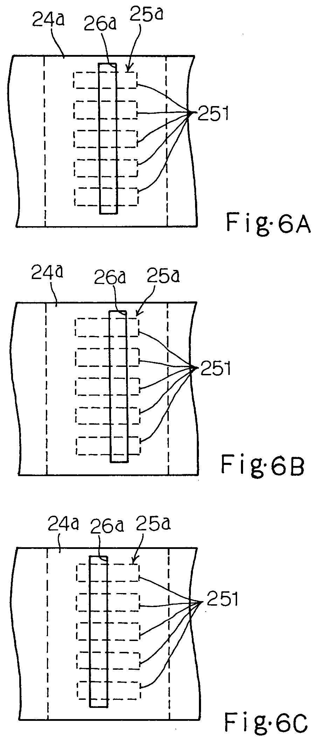

Photoresist solution is spun onto the entire surface of the structure, and a mask for source contact holes is provided over the photoresist film. Ultra-violet light is radiated through the mask, and the void pattern of the mask is transferred to the photoresist film. The photoresist film is then developed, and a photoresist film is patterned in such a manner that contact hole forming areas of the silicon oxide film 22 are exposed through the patterned photoresist film. Appropriate etchant removes the contact hole forming areas, and the source contact holes 26a and 26b are formed in the silicon oxide film 22. In this stage, if the mask is properly aligned, the source contact holes 26a and 26b are located in the central zone of the column of the ohmic contact sub-regions 251 as shown in Fig. 6A. However, if misalignment takes place, the source contact holes 26a and 26b are deviated from the central zone to either side as shown in Figs. 6B and 6C. As described hereinbefore, each of the contact holes 26a and 26b is narrower than the lateral length of the associated column of ohmic contact sub-regions 251 or 252, the lateral displacement due to the misalignment is taken up, and the total amount of source contact area as well as the total amount of ohmic contact area are substantially constant. As a result, the source contact resistance is not affected by the misalignment, and the transistor characteristics are, accordingly, stable. Moreover, the designer can determine the width of the source contact holes 26a and 26b without consideration of the misalignment, and no additional area is added to the heavily doped n-type source regions 24a and 24b. This results in that the occupation area assigned to the vertical field effect transistor is minimized in the lateral direction, and the vertical field effect transistor is desirable in view of scaling-down of the field effect transistor.

### Second Embodiment

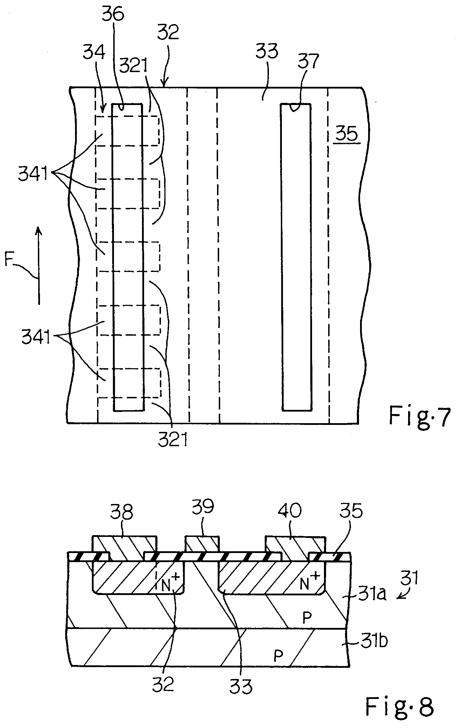

Turning to Figs. 7 and 8 of the drawings, another field effect transistor embodying the present invention is fabricated on a semiconductor substrate 31 with a p-type epitaxial silicon layer 31a grown on a p-type silicon bulk 31b. The semiconductor substrate 31 serves as a back gate of the field effect transistor, and heavily doped n-type source and drain regions 32 and 33 are formed in the p-type epitaxial silicon layer 31a laterally spaced apart from one another. In the heavily doped n-type source region 32 are formed a heavily doped p-type ohmic contact region 34 which are implemented by a column of ohmic contact sub-regions 341 as shown in Fig. 7, and the ohmic contact sub-regions 341 are held in contact with the p-type epitaxial silicon layer 31a. The column of ohmic contact sub-regions 341 are arranged in such a manner as to extend in a first direction F, and the ohmic contact sub-regions 341 are spaced apart from one another. Therefore, source contact sub-regions 321 are formed between the ohmic contact sub-regions 341, and the source contact sub-regions 321 alternate with the ohmic contact sub-regions 341.

The p-type epitaxial silicon layer 31a, the source and drain regions 32 and 33 and the ohmic contact region 34 are covered with a thermally grown silicon oxide film 35, and source and drain contact holes 36 and 37 are formed in the thermally grown silicon oxide film 35. The source contact hole 36 exposes the column of ohmic contact sub-regions 341 and the source contact sub-regions 321, and the drain contact hole 37 is located over the heavily doped n-type drain region 33. Tough not shown in Fig. 7, a source electrode 38, a gate electrode 39 and a drain electrode 40 are formed on the thermally grown silicon oxide film 35 at spacings, and the gate electrode 39 is located over a channel region between the source and drain regions 32 and 33. The source electrode 38 passes through the source contact hole 36, and are held in contact with the column of ohmic contact sub-regions 341 and the source sub-regions 321. The drain electrode 40 also passes through the drain contact hole 37, and is held in contact with the heavily doped n-type drain region 33.

The source and drain contact holes 36 and 37 are patterned through a lithographic process as similar to the first embodiment, and misalignment is liable to take place. However, the source contact hole 36 is narrower than the lateral length of the ohmic contact sub-regions 341, and the total amount of source contact area as well as the total amount of ohmic contact area are constant. In other words, the field effect transistor implementing the second embodiment also achieves the advantages of the first embodiment.

Although particular embodiments of the present invention have been shown and described, it will be obvious to those skilled in the art that various changes and modifications may be made without departing from the spirit and scope of the present invention. For example, the conductivity types of the embodiments are exchangeable, and p-channel field effect transistor may be fabricated in accordance with the present invention. Moreover, the n-channel type field effect transistor according to the present invention may be integrated with p-channel type field effect transistor and further with a bipolar transistor for a CMOS circuit and a Bi-CMOS circuit.

## Claims

1. A field effect transistor fabricated on a semiconductor substrate (21; 31), comprising:
a) a source region (24a/ 24b; 32) formed in said semiconductor substrate, and having a source contact area;
b) a drain region (21a/ 21b; 33) formed in said semiconductor substrate, and spaced apart from said source region by a channel region;
c) a back gate (23a/ 23b; 31a/ 31b) formed in said semiconductor substrate, and associated with said channel region;
d) an ohmic contact region 25a/ 25b; 34) held in contact with said back gate, and having an ohmic contact area;
e) a gate electrode (28; 39) provided in association with said channel region for producing a conductive channel; and
f) a source electrode (27; 38) held in contact with said source contact area as well as said ohmic contact area,
characterized in that said source contact area and said ohmic contact area are respectively broken down into a plurality of source contact sub-areas (241/ 242; 321) and a plurality of ohmic contact sub-areas (251/ 252; 341) arranged in such a manner that said plurality of source contact sub-areas alternate with said plurality of ohmic contact sub-areas in a first direction (F), and in that said source electrode has a pair of long edges extending in parallel to said first direction and a pair of short edges extending in perpendicular to said first direction.

2. A field effect transistor as set forth in claim 1, in which said semiconductor substrate (21) has a first conductivity type (N) and serves as said drain.

3. A field effect transistor as set forth in clam 2, in which said back gate is implemented by first impurity regions (23a/ 23b) formed in a surface portion of said semiconductor substrate and spaced from one another, said first impurity regions having a second conductivity type (P) opposite to said first conductivity type, said source region of said first conductivity type and said ohmic contact region of said second conductivity type being formed in surface portions of said first impurity regions.

4. A field effect transistor as set forth in claim 1, in which said source and drain regions (32/ 33) are laterally spaced apart from each other by said channel region, and are formed in a surface portion of said semiconductor substrate, said source and drain regions having a first conductivity type (N) opposite to a second conductivity type (P) of said semiconductor substrate serving as said back gate, said ohmic contact region having said second conductivity type.

5. A field effect transistor as set forth in claim 1, in which said short edges are shorter than length of said plurality of ohmic contact sub-areas in the direction perpendicular to said first direction.
